# EUROPEAN PATENT APPLICATION

(11) **EP 4 506 097 A1**
(43) Date of publication of application: **12.02.2025**
(21) Application number: 24192829.0
(22) Date of filing: 05.08.2024
(51) Int. Cl.: B23K 26/0622, B23K 26/06, B23K 26/064, B23K 26/082, B23K 26/08, B23K 26/351, B23K 26/352, B23K 26/70, H01L 21/268

(54) **LASER ANNEALING DEVICE, LASER ANNEALING METHOD, AND LASER ANNEALING PROGRAM**

(30) Priority: 07.08.2023 JP 2023128573
(71) Applicant: Sumitomo Heavy Industries, Ltd., Tokyo 141-6025 (JP)
(72) Inventor: MASAOKA, Masaki, Kanagawa, 237-8555 (JP)
(74) Representative: Louis Pöhlau Lohrentz

(57) **Abstract**

A laser annealing device and the like that can appropriately correct a control input value designated by a recipe or the like are provided.

A laser annealing device 1 includes, in a laser control unit 51 that controls a laser pulse LP with which a semiconductor wafer 3 is irradiated from a laser device 2 for an annealing process, based on a control parameter, a correction value setting unit 62 capable of setting different correction values for a plurality of control input values CI of the control parameter, and a control input unit 61 that, in a case where any of the plurality of control input values CI is designated for controlling the laser pulse LP, inputs a corrected control input value ACI obtained by correcting the control input value CI using the corresponding correction value into the laser device 2. The control parameter is energy density of the laser pulse LP.

## Description

### BACKGROUND OF THE INVENTION

### Field of the Invention

The present disclosure relates to a laser annealing device and the like.

### Description of Related Art

Japanese Unexamined Patent Publication No. 2018-67642 discloses a laser annealing device that performs an annealing process by irradiating a workpiece such as a semiconductor wafer with a laser beam. The laser beam is controlled based on various control parameters such as energy density. Specific values (hereinafter, also referred to as control input values) of the control parameters of the laser beam used in the actual annealing process are generally designated in a document called a recipe that defines a processing condition and a processing procedure of the laser annealing device.

### SUMMARY OF THE INVENTION

In a case of using a plurality of the same (for example, having the same model number) laser annealing devices, the same recipe results in the same processing result. However, in a case where there is an individual difference the individual laser annealing devices, even the same recipe may result in different processing results.

The present disclosure has been conceived in view of such circumstances, and an object of the present disclosure is to provide a laser annealing device and the like that can appropriately correct a control input value designated by a recipe or the like.

In order to solve the problem, a laser annealing device according to an aspect of the present disclosure includes, in a laser control unit that controls a laser beam with which a workpiece is irradiated from a laser device for an annealing process, based on a control parameter, a correction value setting unit capable of setting different correction values for a plurality of control input values of the control parameter, and a control input unit that, in a case where any of the plurality of control input values is designated for controlling the laser beam, inputs a corrected control input value obtained by correcting the control input value using the corresponding correction value into the laser device.

According to the present aspect, a correction value that may be different is set for the plurality of control input values that may be designated by a recipe or the like. Each control input value can be appropriately corrected using the correction value finely set for each control input value.

Another aspect of the present disclosure is a laser annealing method. The method includes setting a correction value that may be different for a plurality of control input values of a control parameter for controlling a laser beam with which a workpiece is irradiated for an annealing process, and inputting, in a case where any of the plurality of control input values is designated for controlling the laser beam, a corrected control input value obtained by correcting the control input value using the corresponding correction value for controlling the laser beam.

Any combination of the above components and representation thereof converted into a method, a device, a system, a recording medium, a computer program, and the like are also included in the present disclosure.

According to the present disclosure, a control input value designated by a recipe or the like can be appropriately corrected.

### BRIEF DESCRIPTION OF THE DRAWINGS

Fig. 1 schematically illustrates a configuration of a laser annealing device.
Fig. 2 is a schematic functional block diagram of a laser control unit.
Fig. 3 illustrates a specific example of a control input value of energy density before a correction value is set by a correction value setting unit.
Fig. 4 illustrates specific examples of the control input value of the energy density and a corrected control input value after the correction value is set by the correction value setting unit.
Fig. 5 is a graph obtained by plotting the control input value of the energy density illustrated in a first column in Fig. 4 on a horizontal axis and plotting the correction value illustrated in a second column in Fig. 4 on a vertical axis.
Fig. 6 schematically illustrates an example of assistance in manual setting by a correction value generation unit.
Fig. 7 illustrates another example of Fig. 5.

### DETAILED DESCRIPTION OF THE INVENTION

Hereinafter, a form for embodying the present disclosure (hereinafter, also referred to as an embodiment) will be described in detail with reference to the drawings. In description and/or the drawings, the same or equivalent components, members, processes, and the like will be designated by the same reference symbols, and description thereof will not be repeated. A scale and a shape of each illustrated part are conveniently set for simplification of description and are not interpreted as limiting unless otherwise specified. The embodiment is an example and does not limit the scope of the present disclosure. All features and combinations thereof presented in the embodiment are not necessarily essential to the present disclosure. For convenience, the embodiment is presented by decomposing the embodiment into components for each function and/or each function group implementing the embodiment. However, one component in the embodiment may actually be implemented by a combination of a plurality of components as separate bodies, or a plurality of components in the embodiment may actually be implemented by one component as an integrated body.

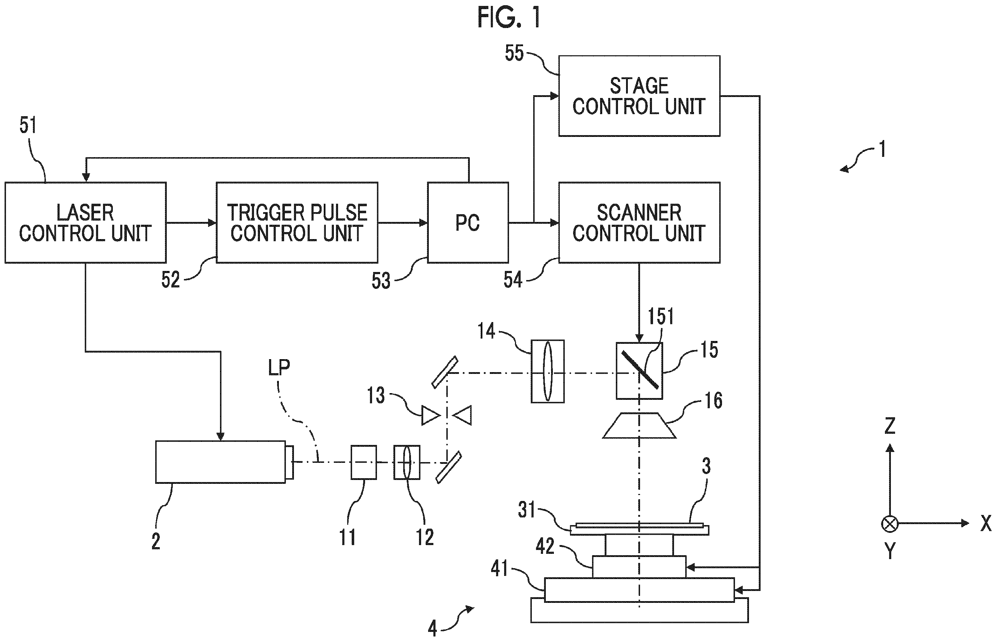

Fig. 1 schematically illustrates a configuration of a laser annealing device 1 according to the embodiment of the present disclosure. The laser annealing device 1 is a device that performs an annealing process (heating process) by irradiating a semiconductor wafer 3 (mounted on a wafer table 31 fixed to a stage device 4, described later) as a workpiece with a laser beam (for example, a laser pulse LP) oscillated by a laser device 2. The laser annealing device 1 in the illustrated example is significantly simplified from the actual one and does not include many components (for example, a component for measuring the laser beam or the semiconductor wafer 3, a component for transporting the semiconductor wafer 3, and a component for stopping irradiation with the laser beam in an emergency) not described in the present embodiment.

The illustrated configuration is merely an example, and the present disclosure may be applied to a laser annealing device having any different configuration. For example, while a control system is configured with a laser control unit 51, a trigger pulse control unit 52, a personal computer (PC) 53, a scanner control unit 54, and a stage control unit 55 in the illustrated example, a control system having any different configuration may be provided as long as the laser annealing device 1 and the laser device 2 can appropriately perform the annealing process on the semiconductor wafer 3. While an energy adjustment mechanism 11, a transmission optical system 12, a mask 13, an irradiation optical system 14, a galvanometer scanner 15, a fθ lens 16, and the like are provided along a path of the laser beam in the illustrated example, any other components may be provided between the laser device 2 and the semiconductor wafer 3 in any disposition as long as the semiconductor wafer 3 is appropriately irradiated with the laser beam from the laser device 2.

Hereinafter, directions related to the configuration and/or an action of the laser annealing device 1 will be described based on a three-dimensional orthogonal coordinate system having each of X, Y, and Z axes orthogonal to each other as a coordinate axis. Hereinafter, for convenience, an X direction and a Y direction will indicate a horizontal direction (that is, an XY plane is a horizontal plane), and a Z direction will indicate a vertical direction. As will be described later, the semiconductor wafer 3 is relatively driven in the XY plane with respect to the laser beam from the laser device 2 under control of the scanner control unit 54 and/or the stage control unit 55.

For example, the semiconductor wafer 3 is driven in the X direction (in this case, the X direction is also referred to as a driving direction) in an integrated manner with a moving table 41 of the stage device 4 that is driven in the X direction by the stage control unit 55. The laser beam from the laser device 2 is scanned in the Y direction (in this case, the Y direction is also referred to as a scanning direction) by the galvanometer scanner 15 that is controlled by the scanner control unit 54. The semiconductor wafer 3 is also driven in the Z direction in an integrated manner with a raising and lowering table 42 of the stage device 4 that is driven in the Z direction by the stage control unit 55 (in this case, the Z direction is also referred to as a raising and lowering direction). The Z direction is also an incidence direction in which the laser beam is incident into the semiconductor wafer 3. Hereinafter, for convenience, the X direction will also be referred to as a longitudinal direction. The Y direction will also be referred to as a lateral direction. The Z direction will also be referred to as a height direction.

For example, the laser device 2 is a pulsed laser device that oscillates the laser pulse LP with a frequency of 100 kHz or higher under control of the laser control unit 51. In order to sufficiently obtain an action and an effect of the laser annealing device 1 according to the present embodiment, for example, the frequency of the laser pulse LP oscillated by the laser device 2 is between 100 kHz and 10 MHz, preferably between 500 kHz and 5 MHz, and more preferably between 700 kHz and 3 MHz. In the example of the present embodiment, the frequency of the laser pulse LP oscillated by the laser device 2 is 1 MHz unless otherwise specified. For example, the laser device 2 according to the present embodiment may be configured with a fiber laser device that oscillates the laser pulse LP via an optical fiber.

For example, the laser pulse LP exits in the X direction from the laser device 2. In the laser annealing device 1 in which the laser pulse LP is guided to the semiconductor wafer 3 of an irradiation target (workpiece), the energy adjustment mechanism 11, the transmission optical system 12, the mask 13, the irradiation optical system 14, the galvanometer scanner 15, and the fθ lens 16 are provided in this order along the path of the laser pulse LP (schematically illustrated by a dot-dashed line).

The energy adjustment mechanism 11 adjusts energy or energy density of the laser pulse LP that has exited from the laser device 2, to a value suitable for a desired annealing process. As will be described later, while the energy density as a control parameter of the laser pulse LP is corrected in the present embodiment, at least a part of this correction may be reflected on the energy adjustment mechanism 11 in addition to or instead of the laser device 2.

The transmission optical system 12 is an optical system for transmitting the laser pulse LP. The transmission optical system 12 is configured with any optical element such as a lens, a mirror, a prism, a filter, or a diffraction grating and may be used for not only transmitting the laser pulse LP but also, for example, adjusting a size (diameter) of the laser pulse LP, shaping the laser pulse LP, and adjusting an intensity distribution of the laser pulse LP. Adjusting the size (diameter) of the laser pulse LP and shaping the laser pulse LP may be performed by the mask 13 having a size (diameter) and/or a shape suitable for the desired annealing process. The irradiation optical system 14 is configured with any optical element such as a lens, a mirror, a prism, a filter, or a diffraction grating and adjusts the laser pulse LP to an aspect (for example, a size (diameter), a shape, and an intensity distribution) suitable for irradiating the semiconductor wafer 3.

The galvanometer scanner 15 is a laser scanning unit that scans the laser pulse LP adjusted by the irradiation optical system 14 or the like along the Y direction. The galvanometer scanner 15 includes a galvanometer mirror 151 as a drivable optical element that reflects the incident laser pulse LP to a desired scanning position in the Y direction, and a motor (not illustrated) that drives the galvanometer mirror 151 to a desired posture or a desired angle. By adjusting the posture or the angle of the galvanometer mirror 151 via the motor, the laser pulse LP incident into the galvanometer mirror 151 is reflected to the desired position in the Y direction.

The laser scanning unit that directs the incident laser pulse LP to the desired scanning position in the Y direction is not limited to the galvanometer scanner 15 and may be configured with an optical element such as a polygon mirror scanner including a rotationally drivable polygon mirror (optical element) or a drivable micro electro mechanical systems (MEMS) mirror. The scanning direction of the laser pulse LP achieved by the laser scanning unit such as the galvanometer scanner 15 is also not limited to the Y direction and may be a direction such as the X direction intersecting with the Y direction or two directions of the X direction and the Y direction. Like the latter, in a case where the laser scanning unit such as the galvanometer scanner 15 can scan the laser pulse LP over the XY plane, that is, a surface of the semiconductor wafer 3, the stage device 4 (moving table 41) that drives the semiconductor wafer 3 and the wafer table 31 in the X direction or the like may not be provided. In this case, a laser scanning unit in two directions of the X direction and the Y direction is configured with the galvanometer scanner 15 or the like.

The fθ lens 16 condenses the laser pulse LP scanned in the Y direction by the galvanometer scanner 15 on the semiconductor wafer 3 of an annealing target. The laser pulse LP from the fθ lens 16 is incident into the semiconductor wafer 3 in the Z direction. The laser pulse LP condensed on the semiconductor wafer 3 by the fθ lens 16 is moved on the surface of the semiconductor wafer 3 in the Y direction by scanning in the Y direction by the galvanometer scanner 15. The size of the laser pulse LP condensed on the semiconductor wafer 3 can be designed to be any size but is, for example, preferably between 0.10 mm square and 0.15 mm square and more preferably between 0.12 mm square and 0.13 mm square. A scanning speed of the laser pulse LP in the Y direction on the surface of the semiconductor wafer 3 (and/or a driving speed of the semiconductor wafer 3 in the X direction achieved by the stage device 4 (moving table 41)) can also be designed to be any speed but is, for example, preferably between 100 cm/s and 500 cm/s and more preferably between 250 cm/s and 350 cm/s.

The moving table 41 of the stage device 4 is a driving device that relatively drives the semiconductor wafer 3 and the wafer table 31 along the X direction with respect to the laser pulse LP. The laser pulse LP is relatively moved on the surface of the semiconductor wafer 3 in the X direction by the moving table 41.

As described above, by combining scanning of the laser pulse LP in the Y direction by the galvanometer scanner 15 as a laser scanning unit in the Y direction with driving of the semiconductor wafer 3 in the X direction by the moving table 41 as a laser scanning unit in the X direction, the laser pulse LP can be scanned over the XY plane, that is, the surface of the semiconductor wafer 3. The driving direction of the semiconductor wafer 3 achieved by the moving table 41 is not limited to the X direction and may be a direction such as the Y direction intersecting with the X direction or two directions of the X direction and the Y direction. Like the latter, in a case where the moving table 41 can relatively drive the semiconductor wafer 3 over the XY plane with respect to the laser pulse LP, the galvanometer scanner 15 that scans the laser pulse LP in the Y direction or the like may not be provided. In this case, a laser scanning unit in two directions of the X direction and the Y direction is configured with the moving table 41.

The laser annealing device 1 and the laser device 2 as described above are controlled by the control system including the laser control unit 51, the trigger pulse control unit 52, the personal computer 53, the scanner control unit 54, and the stage control unit 55.

The laser control unit 51 controls the laser pulse LP oscillated by the laser device 2 based on various control parameters. Examples of the control parameters include the energy of the laser pulse LP, the energy density of the laser pulse LP, a repetition frequency of the laser pulse LP, a duration (pulse width) of the laser pulse LP, peak intensity of the laser pulse LP, a profile (for example, the intensity distribution) of the laser pulse LP, a delay time (time difference) in irradiating the same location with the laser pulse LP via a plurality of laser devices 2 (not illustrated), and an overlap ratio (a ratio of an overlap between irradiation marks) between adjacent rows (or adjacent columns) in a case where the laser pulse LP is scanned in a reciprocating manner. Hereinafter, the energy density of the laser pulse LP will be specifically described as a representative example of the control parameters. However, the following description is also applicable to any other control parameters used by the laser device 2.

The trigger pulse control unit 52 generates a trigger pulse that is synchronized with the laser pulse LP oscillated by the laser device 2, based on a synchronization signal provided from the laser control unit 51. For example, a frequency of the trigger pulse generated by the trigger pulse control unit 52 is 1/N (N is any natural number) times or N times the repetition frequency or the oscillation frequency of the laser pulse LP.

The scanner control unit 54 controls the galvanometer scanner 15 (scanner control) based on the trigger pulse that is processed by the personal computer 53, as necessary. Similarly, the stage control unit 55 controls the moving table 41 (stage control) of the stage device 4 based on the trigger pulse that is processed by the personal computer 53, as necessary. Based on the trigger pulse synchronized with the laser pulse LP, the scanner control unit 54 can appropriately execute scanning of the laser pulse LP in the Y direction by the galvanometer scanner 15, and the stage control unit 55 can appropriately execute driving of the semiconductor wafer 3 in the X direction by the moving table 41. The personal computer 53 may be used for adjustment in the laser control unit 51, which will be described below.

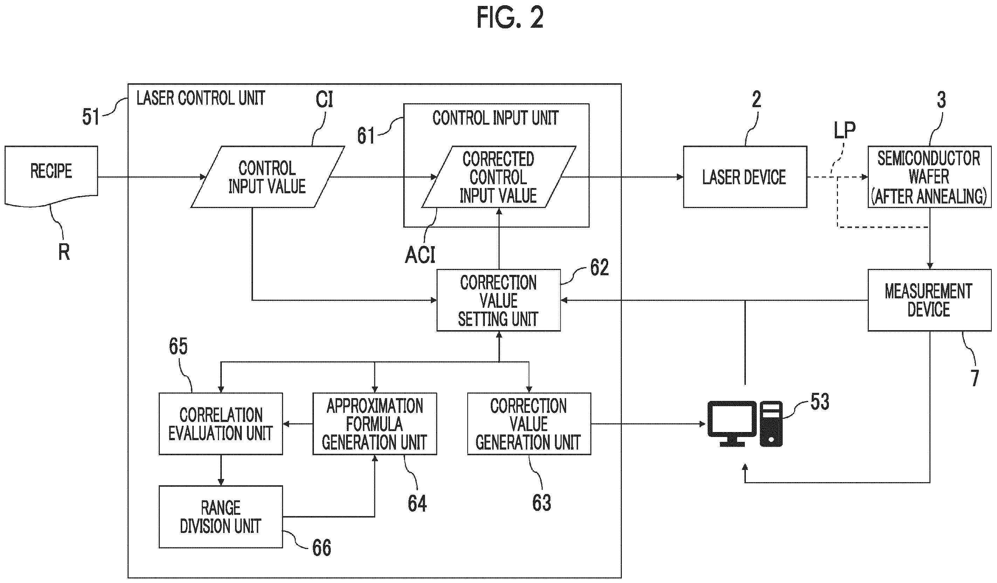

Fig. 2 is a schematic functional block diagram of the laser control unit 51 according to the present embodiment. The laser control unit 51 includes a control input unit 61, a correction value setting unit 62, a correction value generation unit 63, an approximation formula generation unit 64, a correlation evaluation unit 65, and a range division unit 66. A part of these functional blocks may be omitted as long as the laser control unit 51 can implement at least a part of actions and/or effects described below. These functional blocks may be implemented by cooperation between hardware resources such as a central processing unit, a memory, an input device, and an output device of a computer and a peripheral device connected to the computer and software executed using the hardware resources. Regardless of a type or an installation location of the computer, each of the functional blocks may be implemented by a hardware resource of a single computer or be implemented by combining hardware resources distributed between a plurality of computers.

The control input unit 61 inputs a control input value designated for controlling the laser pulse LP into the laser device 2. In the illustrated example, a specific control input value of the control parameter such as the energy density of the laser pulse LP is designated by a recipe R that defines a processing condition and a processing procedure of the laser annealing device 1 and/or the laser device 2. In a typical laser control unit in the related art, a control input value CI designated by the recipe R is input into the laser device 2. Meanwhile, in the laser control unit 51 according to the present embodiment, the control input value CI designated by the recipe R is input into the laser device 2 after being corrected to a corrected control input value ACI by the correction value setting unit 62 described below.

The correction value setting unit 62 can set different correction values for a plurality of control input values CI of the control parameter such as the energy density of the laser pulse LP designated by the recipe R. In a case where any of the plurality of control input values CI is designated by the recipe R for controlling the laser pulse LP, the control input unit 61 inputs the corrected control input value ACI obtained by correcting the control input value CI using a corresponding correction value into the laser device 2. In the present embodiment, the control input unit 61 and the correction value setting unit 62 are described as separate functional blocks for convenience. However, these functional blocks may be implemented as an integrated functional block.

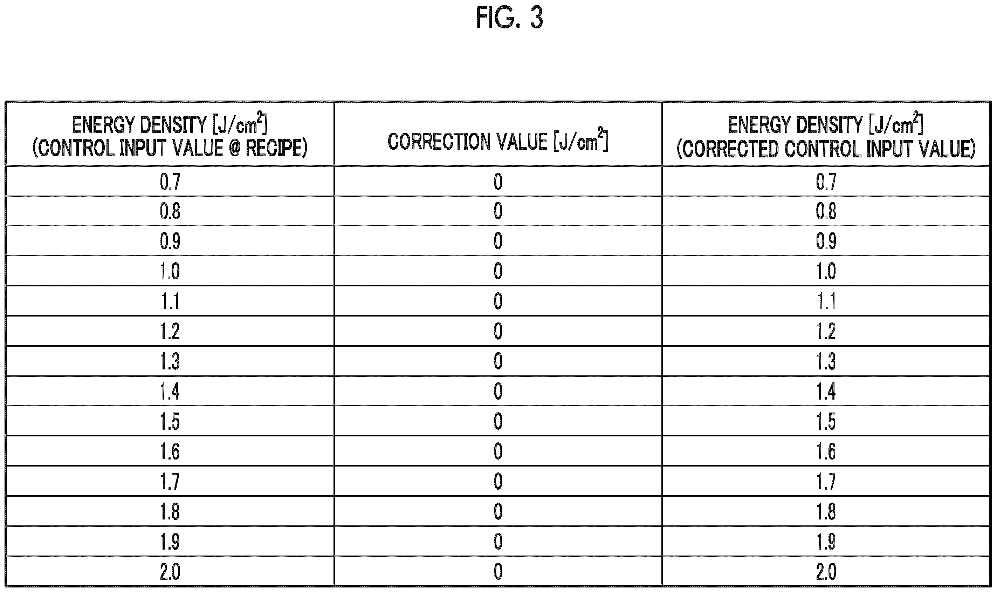

Fig. 3 illustrates a specific example of the control input value CI (corrected control input value ACI) of the energy density before the correction value is set by the correction value setting unit 62. A first column shows the plurality of control input values CI of the energy density designated by the recipe R. In this example, the control input values CI of the energy density designated by the recipe R are at a pitch of 0.1 J/cm². However, as will be described later, the recipe R may designate the control input value CI between the illustrated control input values CI at the pitch of 0.1 J/cm² for controlling the energy density of the laser pulse LP. In the illustrated example, correction values are not set, so all of the correction values are "0". Thus, the plurality of corrected control input values ACI of the energy density shown in a third column are the same as the control input values CI in the first column.

The correction values shown in a second column may be manually set through the personal computer 53 that is operable by a user such as a manager of the laser annealing device 1 and/or the laser device 2. Specifically, the correction value setting unit 62 of the laser control unit 51 sets or writes the correction values shown in the second column based on correction value setting information provided from the personal computer 53 in accordance with an operation of the user.

In manually setting the correction values, a measurement device 7 that measures various characteristics of the semiconductor wafer 3 and/or the laser pulse LP after the annealing process is actually performed using the laser pulse LP based on the control input values CI before correction and/or the corrected control input values ACI after correction may be used. A measurement result of the measurement device 7 is provided to the personal computer 53 and is presented or displayed to the user through a monitor or the like of the personal computer 53. Accordingly, for example, the user can check whether or not the corrected control input values ACI set by the user implement a desired characteristic of the semiconductor wafer 3 and/or the laser pulse LP in substantially real time. In a case where the corrected control input values ACI do not implement the desired characteristic of the semiconductor wafer 3 and/or the laser pulse LP, the user can appropriately update the corrected control input values ACI by operating the personal computer 53.

Instead of the manual setting by the user via the personal computer 53 as described above, the correction value setting unit 62 may autonomously (or automatically) set the correction value for each control input value CI based on the measurement result from the measurement device 7. The correction value setting unit 62 autonomously sets an appropriate correction value for each control input value CI so that the desired characteristic (measured by the measurement device 7) of the semiconductor wafer 3 and/or the laser pulse LP is implemented.

While any characteristic of the semiconductor wafer 3 (after the annealing process) and/or the laser pulse LP may be measured by the measurement device 7, examples of the characteristic include sheet resistance of the semiconductor wafer 3, the control parameter such as the energy density of the laser pulse LP, and power, the intensity distribution, the profile, the size (diameter), and the shape of the laser pulse LP. The correction value setting unit 62 that automatically sets the correction values can set the optimal correction value for each control input value CI with comprehensive reference to these various measurement results.

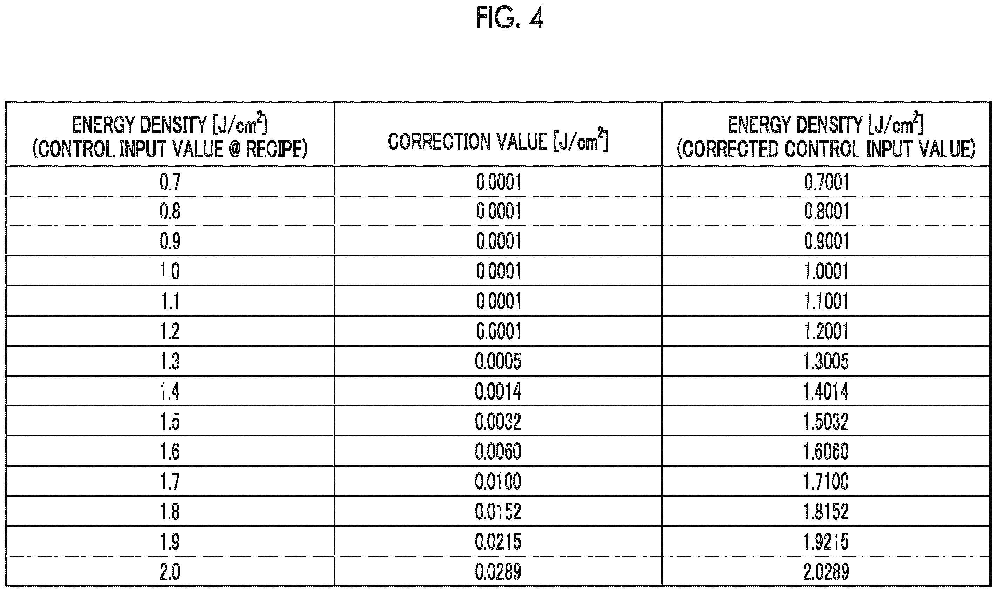

Fig. 4 illustrates a specific example of the control input values CI and the corrected control input values ACI of the energy density after the correction values are set by the correction value setting unit 62. As illustrated here, the correction value setting unit 62 can set different correction values for the plurality of control input values CI of the energy density designated by the recipe R. For example, while a correction value "0.0001" is set for a control input value "0.7" of the energy density designated by the recipe R, a correction value "0.0289" is set for a control input value "2.0" of the energy density designated by the recipe R.

In a case where any (for example, "1.5") of the plurality of control input values CI in the first column is designated by the recipe R for controlling the laser pulse LP, the control input unit 61 inputs the corrected control input value ACI ("1.5032") obtained by correcting the control input value CI ("1.5") using a corresponding correction value ("0.0032") into the laser device 2. That is, in a case where the recipe R designates "1.5" as the energy density, energy density of "1.5032" is actually designated for the laser device 2.

Such correction is mainly performed for reducing an effect of an individual difference between the laser devices 2. In the above example, the energy density of "1.5032" (corrected control input value ACI) actually has to be designated for the laser device 2 in order for the laser device 2 to oscillate the laser pulse LP having the energy density of "1.5" designated by the recipe R. In other words, in a case where the energy density of "1.5" (control input value CI) as in the recipe R is designated for the laser device 2, the laser pulse LP having the desired energy density of "1.5" is not oscillated.

According to the present embodiment, as illustrated in Fig. 4, the correction value can be individually and finely set for each control input value CI designated by the recipe R. Thus, the effect of an individual difference between the laser annealing devices 1 and/or the laser devices 2 can be effectively reduced. For example, in a case of using a plurality of the same (for example, having the same model number) laser annealing devices 1 and/or the same laser devices 2, individually performing the above precise correction for each device (that is, the correction values in the second column may be different for each device) can implement the laser pulse LP having the desired energy density as designated by the recipe R in each device. Accordingly, regardless of the individual difference between the laser annealing devices 1 and/or the laser devices 2, each device can perform the desired annealing process as in the recipe R (that is, the same processing result can be obtained).

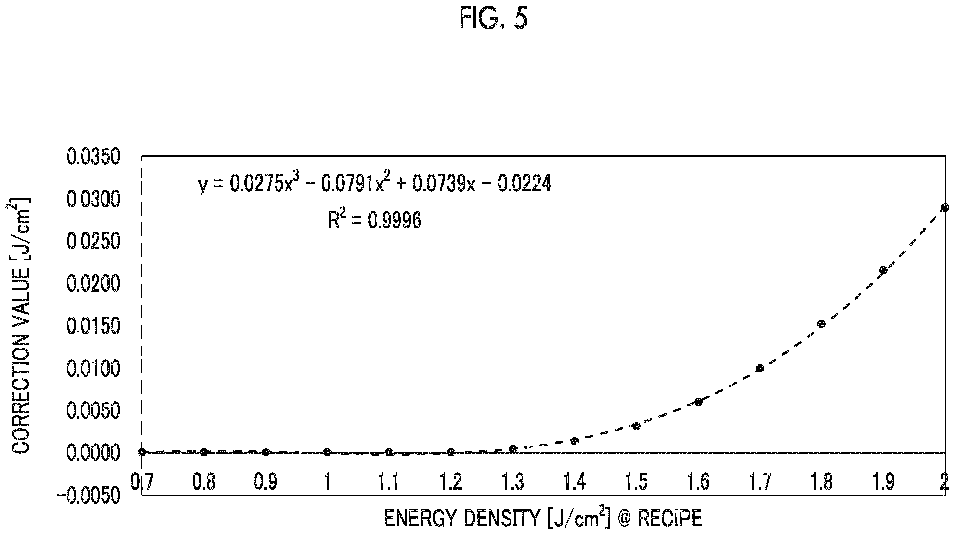

Fig. 5 is a graph obtained by plotting the control input values CI of the energy density designated by the recipe R and illustrated in the first column in Fig. 4 on a horizontal axis and plotting the correction values illustrated in the second column in Fig. 4 on a vertical axis. As in this example, a plurality of correction values may be set by the correction value setting unit 62 (or the personal computer 53) to non-linearly change with respect to the plurality of control input values CI (values at a pitch of 0.1 between 0.7 and 2.0). While illustration is not provided, in this case, the plurality of corrected control input values ACI shown in the third column in Fig. 4 change non-linearly with respect to the plurality of control input values CI shown in the first column. In other words, the correction value and the corrected control input value ACI may be freely set for each control input value CI. Thus, the control input value CI can be precisely corrected in accordance with a characteristic (or the individual difference) unique to the laser annealing device 1 and/or the laser device 2.

Particularly, the energy density as the control parameter of the laser pulse LP significantly affects activation, which is a main purpose of the annealing process, of the semiconductor wafer 3 into which a dopant is implanted. Thus, non-linear or free-form correction as schematically illustrated in Fig. 5 is extremely beneficial for achieving high quality of the annealing process and improving stability of the annealing process.

In the example in Fig. 4, all of the correction values shown in the second column are manually input through the personal computer 53. The correction value generation unit 63 may provide information for assisting in such manual setting to the personal computer 53 and/or the user.

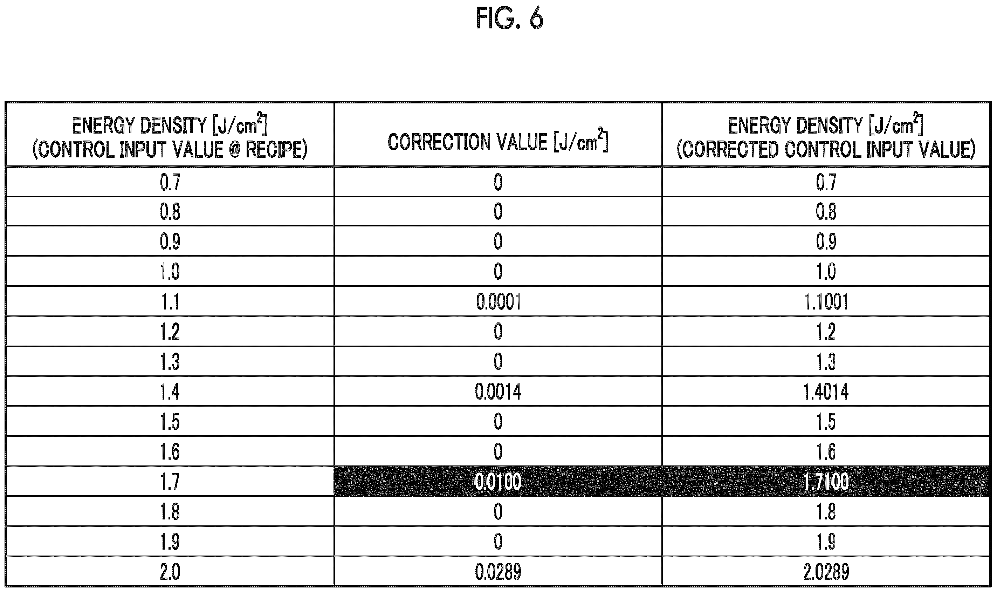

Fig. 6 schematically illustrates an example of assistance in manual setting by the correction value generation unit 63. In this example, correction values "0.0001", "0.0014", and "0.0289" are manually set for control input values "1.1", "1.4", and "2.0" of the energy density (first column), respectively, designated by the recipe R. In a case where at least three correction values (second column) are set for at least three control input values CI (first column), the correction value generation unit 63 generates another correction value for another control input value CI different from the at least three control input values CI based on the at least three correction values.

Specifically, in the illustrated example, the correction value generation unit 63 generates or calculates another correction value "0.0100" for another control input value "1.7" different from three set control input values "1.1", "1.4", and "2.0" based on three set correction values "0.0001", "0.0014", and "0.0289". As schematically illustrated in Fig. 6, the correction value "0.0100" and/or a corrected control input value "1.7100" suggested by the correction value generation unit 63 are presented or displayed in a highlighted manner to the user through the monitor or the like of the personal computer 53. In a case where the suggested correction value and/or the suggested corrected control input value is appropriate, the user sets the suggested correction value and/or the suggested corrected control input value in the correction value setting unit 62 by performing an operation of employing the suggested correction value and/or the suggested corrected control input value using the personal computer 53. In a case where the suggested correction value and/or the suggested corrected control input value is inappropriate, the user performs an operation such as correction using the personal computer 53.

In the example in Fig. 4, the correction value setting unit 62 sets non-linear (or linear) correction values that may be different for the plurality of discrete control input values CI in at a pitch of 0.1. However, the recipe R may designate the control input value CI between the discrete control input values CI for controlling the laser pulse LP. In this case, a correction value set for the discrete control input value CI closest to the designated control input value CI may be used. However, an approximation formula generated by the approximation formula generation unit 64 described below is preferably used.

The approximation formula generation unit 64 generates an approximation formula for calculating a continuous correction value for a continuous control input value based on a plurality of correction values set for the plurality of discrete control input values CI by the correction value setting unit 62 and/or the personal computer 53. Fig. 5 illustrates an example of the approximation formula generated by the approximation formula generation unit 64. A polynomial approximation formula "y = 0.0275x³- 0.0791x² + 0.0739x - 0.0224" (here, x is a horizontal axis variable, and y is a vertical axis variable) is generated by the approximation formula generation unit 64 based on discrete correction values (black points in Fig. 5) set for the discrete control input values CI at a pitch of 0.1 in the example in Fig. 4. In Fig. 5, this polynomial approximation formula is also displayed as a graph of a non-linear dotted curve.

In a case where the recipe R designates an intermediate control input value between the discrete control input values CI at a pitch of 0.1 for controlling the energy density of the laser pulse LP, the correction value setting unit 62 sets an intermediate correction value for the intermediate control input value based on the polynomial approximation formula generated by the approximation formula generation unit 64. For example, in a case where an intermediate control input value "1.55" between two adjacent control input values "1.5" and "1.6" is designated by the recipe R, the correction value setting unit 62 calculates an intermediate correction value "y = 0.0045" by substituting the intermediate control input value "1.55" for "x" in the polynomial approximation formula "y = 0.0275x³ - 0.0791x² + 0.0739x - 0.0224". The intermediate correction value "0.0045" is between one correction value "0.0032" corresponding to one adjacent control input value "1.5" and another correction value "0.0060" corresponding to another adjacent control input value "1.6".

As described above, the control input unit 61 inputs the corrected control input value (for example, 1.5545) obtained by correcting the intermediate control input value (for example, 1.55) designated for controlling the laser pulse LP using the intermediate correction value (for example, 0.0045) calculated from the approximation formula generated by the approximation formula generation unit 64, into the laser device 2. In other words, the control input unit 61 inputs the intermediate control input value (for example, 1.5545) corrected using the intermediate correction value (for example, 0.0045) between one correction value (for example, 0.0032) corresponding to one adjacent control input value (for example, 1.5) and another correction value (for example, 0.0060) corresponding to another adjacent control input value (for example, 1.6) into the laser device 2 as the corrected control input value.

The correlation evaluation unit 65 evaluates a correlation between the plurality of correction values set for the plurality of discrete control input values CI by the correction value setting unit 62 and the approximation formula generated by the approximation formula generation unit 64. In the example in Fig. 5, the correlation evaluation unit 65 calculates a correlation coefficient R² for evaluating the correlation between the plurality of discrete correction values (black points in Fig. 5) set for the plurality of discrete control input values CI at a pitch of 0.1 and the polynomial approximation formula (a dotted line in Fig. 5) generated by the approximation formula generation unit 64. The correlation coefficient R² indicates a stronger correlation as the correlation coefficient R² approaches "1", and a weaker correlation as the correlation coefficient R² approaches "0".

The range division unit 66 divides a range of the control input values CI from which the approximation formula is generated by the approximation formula generation unit 64 into a plurality of small ranges in a case where the correlation evaluated by the correlation evaluation unit 65 falls below a predetermined reference. For example, in a case where the correlation coefficient R² calculated by the correlation evaluation unit 65 falls below a predetermined reference value "0.9", the range division unit 66 performs a range division process. In the example in Fig. 5, since the correlation coefficient R² calculated by the correlation evaluation unit 65 is "0.9996" which is greater than or equal to the reference value "0.9", the range division unit 66 does not execute the range division process.

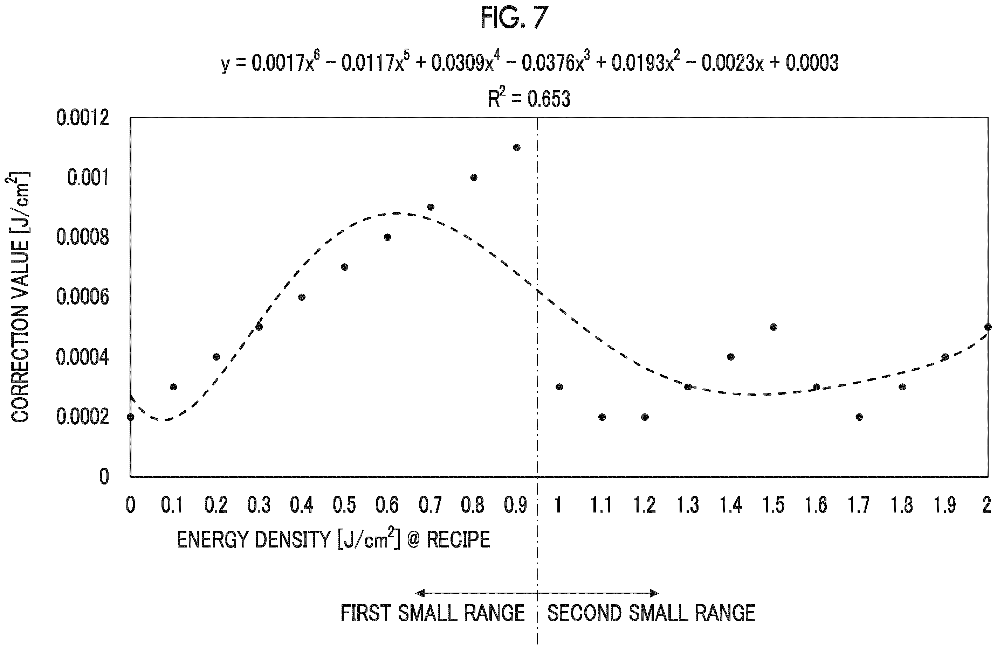

Meanwhile, in another example illustrated in Fig. 7, the correlation coefficient R², which is calculated by the correlation evaluation unit 65, between the plurality of discrete correction values (black points in Fig. 7) set for the plurality of discrete control input values CI at a pitch of 0.1 by the correction value setting unit 62 and the polynomial approximation formula "y = 0.0017x⁶ - 0.0117x⁵ + 0.0309x⁴ - 0.0376x³ + 0.0193x² - 0.0023x + 0.0003" (a dotted line in Fig. 7) generated by the approximation formula generation unit 64 is "0.653" which falls below the reference value "0.9". Thus, the range division unit 66 executes the range division process. As schematically illustrated in Fig. 7, for example, the range division unit 66 divides the range of the control input values CI of a target for generating the approximation formula via the approximation formula generation unit 64 into a first small range of less than or equal to "0.95" and a second small range of greater than or equal to "0.95" considering a distribution, disposition, continuity, and the like of the discrete correction values. A position at which division is performed by the range division unit 66 may be designated by the user through the personal computer 53.

The approximation formula generation unit 64 generates an approximation formula for each small range divided by the range division unit 66. The range division process performed by the range division unit 66 as described above is repeated until the approximation formula generated by the approximation formula generation unit 64 falls below the reference value "0.9" for all small ranges.

The present disclosure has been described above based on the embodiment. Those skilled in the art will perceive that various modification examples can be made to a combination of each component and each process in the illustrated embodiment, and such modification examples fall within the scope of the present disclosure.

A configuration, an action, and a function of each device or each method described in the embodiment can be implemented by hardware resources or software resources or by cooperation between hardware resources and software resources. For example, a processor, a ROM, a RAM, and various integrated circuits can be used as the hardware resources. For example, programs such as an operating system and an application can be used as the software resources.

### Brief Description of the Reference Symbols

- 1: LASER ANNEALING DEVICE
- 2: LASER DEVICE
- 3: SEMICONDUCTOR WAFER
- 4: STAGE DEVICE
- 7: MEASUREMENT DEVICE
- 15: GALVANOMETER SCANNER
- 41: MOVING TABLE
- 51: LASER CONTROL UNIT
- 53: PERSONAL COMPUTER
- 61: CONTROL INPUT UNIT
- 62: CORRECTION VALUE SETTING UNIT
- 63: CORRECTION VALUE GENERATION UNIT
- 64: APPROXIMATION FORMULA GENERATION UNIT
- 65: CORRELATION EVALUATION UNIT
- 66: RANGE DIVISION UNIT
- LP: LASER PULSE

## Claims

1. A laser annealing device (1) comprising:
in a laser control unit (51) that controls a laser beam with which a workpiece is irradiated from a laser device (2) for an annealing process, based on a control parameter,
a correction value setting unit (62) capable of setting different correction values for a plurality of control input values (CI) of the control parameter; and
a control input unit (61) that, in a case where any of the plurality of control input values (CI) is designated for controlling the laser beam, inputs a corrected control input value (ACI) obtained by correcting the control input value (CI) using the corresponding correction value into the laser device (2).

2. The laser annealing device (1) according to claim 1,
wherein the correction value setting unit (62) is capable of setting different correction values for a plurality of discrete control input values (CI), and
in a case where an intermediate control input value between two adjacent control input values (CI) is designated for controlling the laser beam, the control input unit (61) inputs the intermediate control input value corrected using an intermediate correction value between one correction value corresponding to one control input value (CI) and another correction value corresponding to another control input value (CI) into the laser device (2) as the corrected control input value (ACI).

3. The laser annealing device (1) according to claim 2, further comprising:
an approximation formula generation unit (64) that generates an approximation formula for calculating a continuous correction value for a continuous control input value (CI) based on a plurality of correction values set for the plurality of discrete control input values (CI) by the correction value setting unit (62),
wherein the control input unit (61) inputs the corrected control input value (ACI) obtained by correcting the control input value (CI) designated for controlling the laser beam using the correction value calculated from the approximation formula into the laser device (2).

4. The laser annealing device (1) according to claim 3, further comprising:
a correlation evaluation unit (65) that evaluates a correlation between the plurality of correction values set for the plurality of discrete control input values (CI) by the correction value setting unit (62) and the approximation formula; and
a range division unit (66) that, in a case where the correlation evaluated by the correlation evaluation unit (65) falls below a predetermined reference, divides a range of the control input value (CI) from which the approximation formula is generated by the approximation formula generation unit (64) into a plurality of small ranges,
wherein the approximation formula generation unit (64) generates the approximation formula for each small range divided by the range division unit (66).

5. The laser annealing device (1) according to any one of claims 1 to 4,
wherein a plurality of corrected control input values (ACI) change non-linearly with respect to the plurality of control input values (CI).

6. The laser annealing device (1) according to any one of claims 1 to 4, further comprising:
a correction value generation unit (63) that, in a case where at least three correction values are set for at least three control input values (CI) by the correction value setting unit (62), generates another correction value for another control input value (CI) different from the at least three control input values (CI) based on the at least three correction values.

7. The laser annealing device (1) according to any one of claims 1 to 4,
wherein the control parameter is energy density of the laser beam.

8. A laser annealing method comprising:
setting a correction value that may be different for a plurality of control input values (CI) of a control parameter for controlling a laser beam with which a workpiece is irradiated for an annealing process; and
inputting, in a case where any of the plurality of control input values (CI) is designated for controlling the laser beam, a corrected control input value (ACI) obtained by correcting the control input value (CI) using the corresponding correction value for controlling the laser beam.

9. A laser annealing program causing a computer to execute:
setting a correction value that may be different for a plurality of control input values (CI) of a control parameter for controlling a laser beam with which a workpiece is irradiated for an annealing process; and
inputting, in a case where any of the plurality of control input values (CI) is designated for controlling the laser beam, a corrected control input value (ACI) obtained by correcting the control input value (CI) using the corresponding correction value for controlling the laser beam.
